# DEMANDE DE BREVET EUROPEEN

(11) **EP 1 091 419 A1**
(43) Date de publication de la demande: **11.04.2001**
(21) Numéro de dépôt: 00402686.0
(22) Date de dépôt: 29.09.2000
(51) Int. Cl.: H01L 29/86, H01L 29/772, H01L 29/06, H01C 17/22, G01R 31/00, H01L 21/02, H01L 27/07, H01L 27/118

(54) **Potentiomètre intégré et procédé de fabrication correspondant**

(30) Priorité: 05.10.1999 FR 9912381
(71) Demandeur: STMicroelectronics SA, 94250 Gentilly (FR)
(72) Inventeur: Forel, Christophe, 07100 Annonay (FR); Laville Sébastien, 38000 Grenoble (FR); Dufaza, Christian, 34230 St-Pargoire (FR); Auvergne, Daniel, 34980 Montferrier sur Lez (FR)
(74) Mandataire: Casalonga, Axel

(57) **Abrégé**

Le procédé, selon l'invention, est destiné à l'obtention d'une résistance électrique ajustable, dans lequel on applique à un transistor MOS intégré une première tension sur sa source, sa grille et son substrat, et une deuxième tension sur son drain, les première et deuxième tensions étant aptes à amorcer un claquage du transistor MOS par :
- avalanche de la jonction drain/substrat,
- polarisation du transistor bipolaire parasite du transistor MOS,
- claquage irréversible de la jonction drain/substrat,
- court-circuit entre le drain et la source.

## Description

La présente invention concerne le domaine des circuits intégrés analogiques et numériques. Ces circuits doivent utiliser une surface de silicium la plus faible possible afin de réduire les coûts tout en conservant une forte précision.

Or, la demanderesse s'est aperçue que la précision qui est excellente lors de l'étape du tri des plaquettes de silicium, c'est-à-dire de l'élimination des plaquettes présentant des défauts, peut se dégrader lors de l'étape ultérieure d'encapsulation. A titre d'exemple, pour un amplificateur opérationnel, on peut trouver lors du tri des plaquettes des tensions de décalage de l'ordre de 2 mV qui, après ajustement, sont ramenées à 1 mV. Or, la mise en boîtier pour encapsulation crée une dérive supplémentaire ramenant la tension de décalage finale à 1,5 mV. Pour une référence de tension ou un superviseur de tension, lors du tri des plaquettes, la précision est de 0,8%, ramenée à 0,2% après ajustement. Comme pour l'amplificateur, la mise en boîtier introduit une dérive ramenant la précision finale à 0,5%.

La présente invention a donc pour objet de pouvoir ajuster les circuits intégrés après leur mise en boîtier, notamment les circuits intégrés standard produits en grande série et à faible coût. Le but est d'obtenir une précision très élevée, au moins égale à celle obtenue après ajustement lors du tri des plaquettes.

Le procédé, selon l'invention, est destiné à l'obtention d'une résistance électrique ajustable, dans lequel on applique à un transistor MOS intégré une première tension sur sa source, sa grille et son substrat, et une deuxième tension sur son drain, les première et deuxième tensions étant aptes à amorcer un claquage du transistor MOS par :
- avalanche de la jonction drain/substrat,
- polarisation du transistor bipolaire parasite du transistor MOS,
- claquage irréversible de la jonction drain/substrat,
- court-circuit entre le drain et la source.

Avantageusement, la résistance électrique obtenue est ajustable de façon unidirectionnelle, sa valeur étant déterminée par le courant du aux première et deuxième tensions et pouvant être modifiée par application d'autres tensions avec une limitation en courant plus élevée, les première et deuxième tensions étant fournies par un générateur avec limitation de courant.

Dans un mode de réalisation de l'invention, l'une des première et deuxième tensions est constante, et l'autre tension est une rampe à évolution monotone.

Dans un mode de réalisation de l'invention, l'application des première et deuxième tensions a lieu avant une étape d'encapsulation d'un circuit dont fait partie le transistor MOS.

Dans un autre mode de réalisation de l'invention, l'application des première et deuxième tensions a lieu après une étape d'encapsulation d'un circuit dont fait partie le transistor MOS. La commande du claquage du transistor MOS peut être effectuée par les broches classiques du circuit intégré : masse, alimentation, entrée(s), sortie(s).

La présente invention a également pour objet un composant électronique actif intégré, comprenant un transistor MOS. Le dit transistor MOS est claqué par avalanche de la jonction drain/substrat, polarisation du transistor bipolaire parasite du transistor MOS, claquage irréversible de la jonction drain/substrat, et court-circuit entre le drain et la source, de façon que le dit composant forme une résistance ajustable de valeur déterminée par le courant du à la différence de tension entre drain et source du transistor MOS.

La présente invention a également pour objet un circuit électronique comprenant au moins deux composants du type décrit ci-dessus pour former une résistance électrique ajustable de façon bidirectionnelle.

Dans un mode de réalisation de l'invention, le circuit électronique comprend un transistor MOS, un premier composant du type décrit ci-dessus disposé en parallèle entre le drain et la source du transistor MOS, un deuxième composant du type décrit ci-dessus disposé entre la grille du transistor MOS et la masse, et une source de courant disposée entre la grille et l'alimentation.

L'invention permet donc de proposer des circuits intégrés standard de précision accrue. L'utilisation de transistor MOS dit "snap-back) permet d'obtenir un court-circuit et donc de faire varier une résistance à l'intérieur d'un circuit intégré après son encapsulation en agissant sur les broches classiques du circuit intégré. Le composant ainsi réalisé n'occupe qu'une faible place sur une plaquette de silicium en ce sens qu'il ne comprend qu'un unique transistor MOS. Le fait que la grille et la source du transistor MOS soient court-circuitées garantit son blocage permanent et évite qu'il n'influe sur le fonctionnement des circuits électroniques adjacents.

L'invention met à profilt une caractéristique naturelle des transistors MOS qui est de posséder des composants parasites, en particulier un transistor bipolaire. Dans certaines configurations, ces composants parasites sont néfastes. Lors de décharges électrostatiques, des circuits peuvent être gravement endommagés par mise en conduction du transistor parasite. A l'inverse, l'invention utilise le transistor bipolaire parasite du transistor MOS pour en faire un court-circuit et faire varier la résistance entre le drain et la source du transistor MOS, c'est-à-dire entre le collecteur et l'émetteur du transistor bipolaire parasite.

La présente invention sera mieux comprise à l'étude de la description détaillée de quelques modes de réalisation pris à titre d'exemples nullement limitatifs et illustrés par les dessins annexés, sur lesquels :
la figure 1 est une courbe caractéristique de fonctionnement classique d'un transistor NMOS;
la figure 2 est une vue en coupe transversale d'un transistor MOS;
la figure 3 est un schéma modélisant le transistor MOS et son transistor bipolaire parasite; et
la figure 4 est un schéma d'un circuit mettant en oeuvre l'invention.

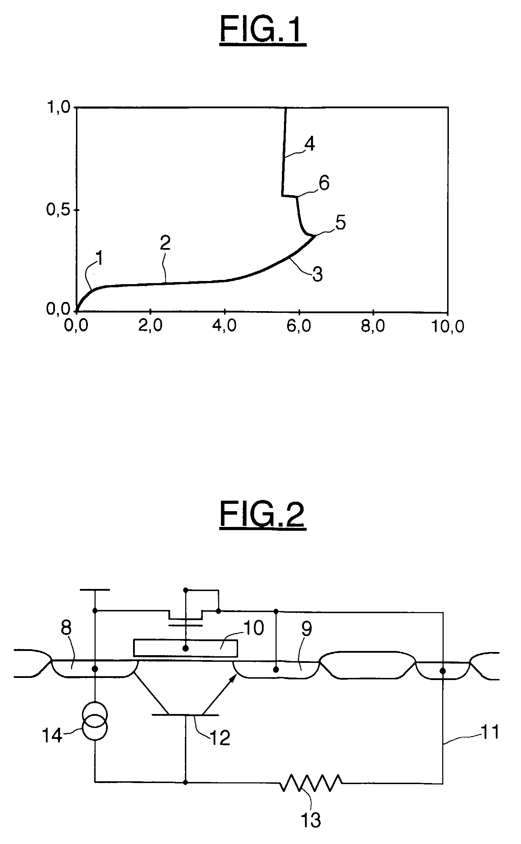

Comme on peut le voir sur la figure 1, où la tension de drain figure en abscisse et le courant de drain en ordonnée, un transistor NMOS possède quatre régions de fonctionnement. La région 1 est celle du fonctionnement linéaire classique d'un transistor MOS. La région 2 est celle du fonctionnement en régime saturé où le courant n'évolue que très faiblement en fonction de la tension. La région 3 est dite "d'avalanche" avec un affaiblissement de la jonction drain/substrat causé par l'avalanche de ladite jonction. Enfin, la région 4 est celle de la mise en conduction du transistor bipolaire parasite avec sur la courbe une première brisure référencée 5 et qui est réversible et une seconde brisure référencée 6 et qui est destructive donc irréversible.

Au-delà de la seconde brisure 6, on remarque que le courant évolue extrêmement rapidement en fonction de la tension, la pente de la courbe étant quasiment verticale. Le processus de brisure également appelé "second breakdown " étant irréversible, on peut se déplacer sur la courbe en partant de la seconde brisure 6 et en se déplaçant vers le haut, ce qui se traduit par une diminution de la résistance que présente le transistor MOS ainsi claqué dans la mesure où pour une tension de drain sensiblement constante, on voit que le courant augmente.

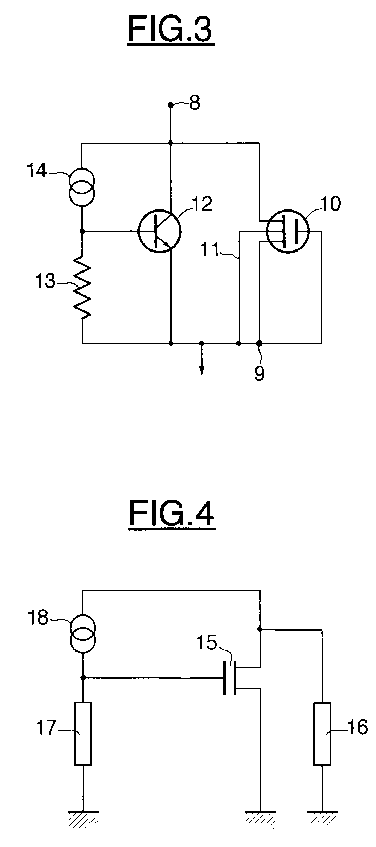

Sur les figures 2 et 3, est représentée la structure des différents constituants. Le transistor MOS comprend un drain 8, une source 9 et un grille 10 formés sur un substrat 11. Dans le substrat 11, se forme un transistor bipolaire parasite 12 dont le collecteur est formé par le drain 8, dont l'émetteur est formé par la source 9 et dont la base peut être modélisée comme étant reliée à la masse par une résistance de substrat 13 et par une source de courant 14 reliée au drain 8.

Dans le montage conforme à l'invention, le drain 8 est relié à une première tension d'alimentation, tandis que la source 9, la grille 10 et le substrat 11 sont court-circuités et reliés à une deuxième tension d'alimentation. A partir du régime de saturation du transistor MOS, une tension élevée sur le drain déclenche l'avalanche de la jonction drain/substrat par génération de paires électrons-trous, créant ainsi un courant de substrat. La tension aux bornes de la résistance de substrat augmente, polarisant ainsi la jonction source/substrat. Le transistor bipolaire parasite est ainsi amorcé, le phénomène de brisure se produit alors.

A fort courant, le composant rentre en régime de seconde brisure irréversible et qui se traduit par une destruction du réseau cristallin de polysilicium du canal formé entre le drain et la source. Après l'avalanche de la jonction collecteur-base du transistor bipolaire parasite, l'émetteur relié à la masse permet de mettre en direct la jonction base-émetteur, ce qui engendre l'effet de retournement ou snap-back. Pour déclencher le phénomène d'avalanche, il faut imposer une tension sur le drain suffisante pour mettre en inverse la jonction drain/substrat. Cette tension dépend des caractéristiques de dopage et est proportionnelle au carré du champ électrique.

Le générateur de courant 14 que l'on a représenté sur les figures 2 et 3 entre le collecteur et la base du transistor bipolaire parasite simule dans un premier temps les courants de fuite de la jonction drain/substrat. Par la suite, il permet de simuler l'avalanche de la jonction et la polarisation du transistor bipolaire parasite de type NPN.

A titre d'exemple, des essais ont été réalisés en technologie HF4 CMOS avec un transistor NMOS dont le canal est à dimensions suivantes : largeur = 1 µm, longueur = 0,7 µm. La source est à la masse et une rampe de tension évoluant de 8 à 18 volts avec une limitation en courant est appliquée sur le drain. Pour un courant de 2 mA, une résistance après claquage de 300 Ohms se forme. Pour un courant de 10 mA, on a obtenu une résistance après claquage de 60 Ohms et pour un courant de 100 mA, on a obtenu une résistance après claquage de 11 Ohms. On remarque que pour une tension de drain inférieure à 11 volts, la jonction drain/substrat n'est pas en avalanche, donc aucun courant ne passe à travers le canal drain/source. Au-delà de cette tension, le phénomène s'enclenche avec création d'un chemin conducteur permettant le passage du courant. Arrivé à la tension de claquage, tout le courant disponible passe dans le canal et une résistance se crée.

Il est particulièrement intéressant d'utiliser des transistors dont le canal est le plus court possible, dans la mesure où plus le canal est court, plus la tension de claquage est faible, en raison de l'augmentation du courant de drain et de l'augmentation du nombre de paires électrons-trous générées, à largeur de canal constante. Une diminution de la largeur de canal se traduit par une diminution de la tension et du courant de la seconde brisure 6 illustrée sur la figure 1. Même si la larguer du canal n'intervient pas dans la tension de la première brisure 5, une largeur réduite augmentera l'effet thermique de la seconde brisure 6 puisque les lignes de champ sont alors plus unidirectionnelles, impliquant une diminution du couple de la seconde brisure. Il est donc particulièrement intéressant d'utiliser des transistors MOS de faibles dimensions.

Dans la pratique, le réglage de la résistance créée par le claquage du MOS dans un circuit intégré après encapsulation devra s'effectuer par les broches classiques utilisées pour les entrées, les sorties, l'alimentation et la masse sans prévoir de broches supplémentaires qui seraient coûteuses et inutiles par la suite. On peut donc prévoir d'imposer une tension positive constante sur l'alimentation et d'imposer une rampe de tension négative sur la masse avec une limitation en courant pour créer la résistance de la valeur souhaitée. Une telle résistance pourra être disposée par exemple à chaque entrée d'un amplificateur opérationnel afin de permettre son équilibrage.

Toutefois, le phénomène de claquage étant irréversible, on ne peut se déplacer dans la région 4 de la courbe de la figure 1 que dans le sens des courants croissants, c'est-à-dire des résistances décroissantes. Dans certaines applications, l'on souhaite obtenir un potentiomètre intégré que l'on puisse régler dans les deux sens en augmentant et en diminuant la résistance. On peut alors utiliser le circuit illustré sur la figure 4 où un transistor MOS 15 est utilisé dans sa région linéaire avec parallèlement à ce transistor 15 un potentiomètre intégré 16 tel que décrit ci-dessus et formé par un transistor MOS claqué, un autre potentiomètre intégré 17 tel que décrit ci-dessus étant connecté entre la grille et la source du transistor MOS 15. Une source de courant 18 relie le drain et la grille du transistor MOS 15.

Ainsi, une diminution de la résistance du composant 16 se traduit par une diminution de la résistance de l'ensemble de ce circuit. Au contraire, une diminution de la résistance du composant 17 se traduit par une diminution de la tension de grille du transistor MOS 15 et une augmentation de la résistance entre le drain et la source dudit transistor MOS 15, celui-ci étant en région linéaire.

Bien entendu, ce circuit ne constitue qu'un exemple de montage de potentiomètre bidirectionnel intégré. D'autres montages comprenant deux potentiomètres intégrés ou plus peuvent être envisagés.

L'invention permet ainsi de mettre à profit une caractéristique naturelle des transistors MOS habituellement considérée comme un inconvénient pour réaliser un potentiomètre intégré dont on peut régler la valeur de la résistance de façon fine pour obtenir des circuits intégrés produits en très grandes séries et présentant une haute précision.

## Revendications

1. Procédé pour obtenir une résistance électrique ajustable, dans lequel on applique à un transistor MOS intégré une première tension sur sa source, sa grille et son substrat, et une deuxième tension sur son drain, les première et deuxième tensions étant aptes à amorcer un claquage du transistor MOS par :
- avalanche de la jonction drain/substrat,
- polarisation du transistor bipolaire parasite du transistor MOS,
- claquage irréversible de la jonction drain/substrat,
- court-circuit entre le drain et la source.

2. Procédé selon la revendication 1, dans lequel la résistance électrique obtenue est ajustable de façon unidirectionnelle, sa valeur étant déterminée par le courant du aux première et deuxième tensions et pouvant être modifiée par application d'autres tensions avec une limitation en courant plus élevée, les première et deuxième tensions étant fournies par un générateur avec limitation de courant.

3. Procédé selon la revendication 1 ou 2, dans lequel l'une des première et deuxième tensions est constante, et l'autre tension est une rampe à évolution monotone.

4. Procédé selon l'une des revendications précédentes, dans lequel l'application des première et deuxième tensions a lieu avant une étape d'encapsulation d'un circuit dont fait partie le transistor MOS.

5. Procédé selon l'une des revendications 1 à 3, dans lequel l'application des première et deuxième tensions a lieu après une étape d'encapsulation d'un circuit dont fait partie le transistor MOS.

6. Procédé selon la revendication 5, dans lequel la commande du claquage du transistor MOS est effectuée par les broches classiques du circuit intégré : masse, alimentation, entrée(s), sortie(s).

7. Composant électronique actif intégré, comprenant un transistor MOS, caractérisé par le fait que le dit transistor MOS est claqué par avalanche de la jonction drain/substrat, polarisation du transistor bipolaire parasite (12) du transistor MOS, claquage irréversible de la jonction drain/substrat, et court-circuit entre le drain (8) et la source (9), de façon que le dit composant forme une résistance ajustable de valeur déterminée par le courant du à la différence de tension entre drain et source du transistor MOS.

8. Circuit électronique, caractérisé par le fait qu'il comprend au moins deux composants (16, 17) selon la revendication 7 pour former une résistance électrique ajustable de façon bidirectionnelle.

9. Circuit électronique selon la revendication 8, caractérisé par le fait qu'il comprend un transistor MOS (15), un premier composant (16) selon la revendication 7 disposé en parallèle entre le drain et la source du transistor MOS, un deuxième composant (17) selon la revendication 7 disposé entre la grille du transistor MOS et la masse, et une source de courant (18) disposée entre la grille et l'alimentation.
